# EUROPÄISCHE PATENTANMELDUNG

(11) **EP 1 349 440 A1**
(43) Veröffentlichungstag der Anmeldung: **01.10.2003**
(21) Anmeldenummer: 02006973.8
(22) Anmeldetag: 27.03.2002
(51) Int. Cl.: H05K 7/14, H01R 12/34, H01R 12/16

(54) **Rückverdrahtungsplatine**

(71) Anmelder: Schroff GmbH, D-75334 Straubenhardt (DE)
(72) Erfinder: Röhrich, Manfred, 76359 Marxzell (DE)
(74) Vertreter: Durm, Frank, Dipl.-Ing.

(57) **Zusammenfassung**

Eine Rückverdrahtungsplatine (3) für elektronische Steckbaugruppen ist an mindestens einer Modulschiene (2) eines Baugruppenträgers befestigbar. Die Rückverdrahtungsplatine (3) ist in gleichartige Abschnitte (4) unterteilt. Sie hat Randbereiche (5) und Signalanschluss-Felder (7), zwischen denen Stromanschluss-Felder (8) von Stromversorgungsanschlüssen (9) vorgesehen sind. Anschlussstücke (11) mit Kontaktstiften (12) sind mit den Stromversorgungsanschlüssen (9) kontaktiert. Die Stromversorgungsanschlüsse (9) eines Stromanschluss-Feldes (8) sowie die Kontaktstifte (12) des zugehörigen Anschlussstückes (11) sind miteinander korrespondierend in Form eines U angeordnet, wobei der U-Rücken zu dem benachbarten Signalanschluss-Feld (7) weist.

## Beschreibung

Die Erfindung betrifft eine Rückverdrahtungsplatine für elektronische Steckbaugruppen, welche an mindestens einer Modulschiene eines Baugruppenträgers befestigbar ist. Eine solche Rückverdrahtungsplatine, die auch Backplane genannt wird, hat wenigstens einen Randbereich mit einem Befestigungsloch, welches zur Befestigung an der Stirnfläche der Modulschiene dient. Die Rückverdrahtungsplatine hat ferner mindestens ein Signalanschluss-Feld sowie wenigstens ein Stromanschluss-Feld von Stromversorgungsanschlüssen, die zwischen dem Signalanschluss-Feld und dem Randbereich angeordnet sind. Die Rückverdrahtungsplatine hat auch zumindest ein Anschlussstück mit Kontaktstiften, die mit den Stromversorgunganschlüssen des zugehörigen Stromanschluss-Feldes kontaktiert sind.

Rückverdrahtungsplatinen zur systematischen Verdrahtung von nebeneinander angeordneten elektronischen Steckbaugruppen in Baugruppenträgern sind seit langem bekannt. Die meist als Mehrlagen-Leiterplatte ausgebildete Backplane wird an der Rückseite der Baugruppenträger mechanisch befestigt. Die Steckbaugruppen, die auf Einschubschienen in den Baugruppenträger eingeschoben werden, weisen an ihren Rückseiten vielpolige Steckverbinder auf. Diese Steckverbinder greifen in korrespondierende Steckerleisten auf der Rückverdrahtungsplatine ein und stellen damit eine elektrische Verbindung der Steckbaugruppen mit der Rückverdrahtungsplatine her.

Die Architektur einer Rückverdrahtungsplatine ist weitgehend von technischen Normen vorgegeben. Eine normgerechte Rückverdrahtungsplatine weist entlang ihren oberen und unteren Längskanten freie Randbereiche zum Zwecke der Befestigung auf. In diesen freien Randbereichen liegen die Befestigungsbohrungen. Die hinteren Modulschienen des Baugruppenträgers liegen an diesen Randbereichen der Rückverdrahtungsplatine an. Dabei greifen Verbindungsschrauben durch die Befestigungslöcher der Rückverdrahtungsplatine hindurch in die Modulschienen des Baugruppenträgers ein.

Auf der Rückverdrahtungsplatine sind zwischen den Randbereichen Felder von Signalanschlusspunkten vorgesehen, die mit den Polen der Steckverbinder korrespondieren. Die Breite eines Signalanschluss-Feldes ist von der entsprechenden Norm vorgegeben und beträgt beispielsweise 20 Millimeter. Die gesamte Breite einer Rückverdrahtungsplatine ergibt sich also stets aus einem Vielfachen der Breite eines Signalanschluss-Feldes zuzüglich der Abstände zwischen den Feldern.

Zwischen den Randbereichen, die der Befestigung dienen, und den Signalanschluss-Feldern bleibt ein von der Norm nicht festgelegter schmaler Streifen. Dieser Zwischenraum, der typischerweise ca. 8 Millimeter beträgt, bietet Platz für die Anordnung von Stromversorgungsanschlüssen. Jedem Signalanschluss-Feld ist dabei ein Stromanschluss-Feld von Stromversorgungsanschlüssen zugeordnet. Beträgt beispielsweise die Breite des Signalanschluss-Feldes 20 Millimeter und der Abstand zwischen dem Signalanschluss-Feld und dem unteren bzw. oberen Randbereich 8 Millimeter, so steht für das Stromanschluss-Feld von Stromversorgungsanschlüssen eine Fläche von maximal 8 x 20 Millimeter für die Stromeinspeisung zur Verfügung. Zur Verbindung mit einer externen Stromversorgung dienen spezielle Anschlussstücke, die Kontaktstifte aufweisen, die mit den Stromversorgungsanschlüssen kontaktiert sind. In der Regel sind die Stromversorgungsanschlüsse als durchkontaktierte Löcher ausgebildet und die Anschlussstücke mitsamt den Kontaktstiften sind aus Blech geformt. Die Kontaktstifte greifen in die durchkontaktierten Löcher ein.

Aufgrund immer höherer Packungsdichte der elektronischen Bauelemente sowie deren fortschreitende Miniaturisierung benötigen die elektronischen Steckbaugruppen, die mit der Rückverdrahtungsplatine verbunden sind, immer mehr Strom. Da die zur Verfügung stehende Fläche für die Stromeinspeisung jedoch durch die jeweilige Norm begrenzt ist, kommt es darauf an, die Stromversorgungsanschlüsse einer Rückverdrahtungsplatine möglichst optimal zu gestalten.

Aus der deutschen Gebrauchsmusterschrift DE 92 01 083 U ist eine mehrlagige Rückwand-Busplatine bekannt, bei welcher jedem Signalanschluss-Feld ein Stromanschluss-Feld von sechs Stromversorgungsanschlüssen zugeordnet ist. Die Stromversorgungsanschlüsse eines Stromanschluss-Feldes sind in zwei parallelen Reihen von je drei Anschlüssen angeordnet, die alle untereinander elektrisch leitend verbunden sind. Zur Verbindung mit der externen Stromversorgung sind Stromschienen vorgesehen, die an der Unterseite korrespondierend zu den Stromversorgungsanschlüssen angeordnete Stifte tragen.

Bekannt sind auch metallene Anschlussstücke, sogenannte Powerbugs, die in etwa würfelförmig ausgebildet sind und an ihrer Unterseite sechs Kontaktstifte tragen. Die Kontaktstifte sind korrespondierend zu den Stromversorgungsanschlüssen in zwei parallelen Reihen zu je drei Kontaktstiften angeordnet. Der über ein solches Anschlussstück in die Rückverdrahtungsplatine eingespeiste Strom wird also annähernd gleichmäßig auf die sechs Kontaktstifte bzw. Stromversorgungsanschlüsse aufgeteilt. Zur Verbindung des Anschlussstücks mit der externen Stromversorgung dient ein Kabel, das an das Anschlussstück angeklemmt oder angeschraubt wird.

Die übliche Anordnung der Stromversorgungsanschlüsse in zwei parallelen Reihen zu je drei Anschlüssen, insgesamt also sechs Anschlüsse in einem Stromanschluss-Feld, hat Nachteile. Da die korrespondierenden Kontaktstifte des Anschlussstücks durch die Platine hindurch und auf deren Rückseite herausragen, besteht die Gefahr eines unabsichtlichen Kontakts mit der metallenen Modulschiene des Baugruppenträgers. Denn die Stromversorgungsanschlüsse sind ja, entsprechend der Norm, direkt neben dem Randbereich der Rückverdrahtungsplatine und damit in unmittelbarer Nähe zur Modulschiene angeordnet. Um einen elektrischen Überschlag oder eine elektrisch leitende Verbindung zwischen dem stromführenden Anschlussstück und der Modulschiene zu verhindern, werden spezielle Modulschienen mit geringerer Tiefe verwendet, wobei eine Isolierscheibe zwischen den Rand der Rückverdrahtungsplatine und der um die Dicke der Isolierscheibe gekürzten Modulschiene eingesetzt wird. Auf diese Weise wird der notwendige Abstand zwischen den Kontaktstiften des Anschlussstücks und der Modulschiene gewährleistet. Eine zwischen Modulschiene und Rückverdrahtungsplatine eingesetzte Isolierscheibe macht es jedoch unmöglich, eine auf der Rückseite der Rückverdrahtungsplatine vorgesehene Kontaktfläche mit der Modulschiene und damit mit dem Gehäuse des Baugruppenträgers elektrisch leitend zu verbinden, beispielsweise zu Erdungs- oder Schirmzwecken.

Eine Verringerung der Anzahl der Stromversorgungsanschlüsse , beispielsweise von sechs auf nur vier, kommt nicht in Betracht, denn dann würde ja auch der wirksame Querschnitt für die Stromversorgung in gleichem Maße reduziert werden. Es besteht aber der Bedarf eher, noch höhere Ströme über das Anschlussstück und die Stromversorgungsanschlüsse in die Rückverdrahtungsplatine einzuspeisen.

Angesichts der Nachteile im Stand der Technik stellt sich somit das technische Problem, eine Rückverdrahtungsplatine für Norm-Baugruppenträger so zu gestalten, dass bei Verwendung normgerechter Standard-Modulschienen einerseits möglichst hohe Ströme eingespeist werden können, andererseits aber auch die Modulschiene zuverlässig von den Stromversorgungsanschlüssen und den Kontaktstiften des Anschlussstücks ferngehalten wird.

Bei der Lösung der gestellten Aufgabe wird von einer Rückverdrahtungsplatine der eingangs erwähnten Art ausgegangen. Gelöst wird die Aufgabe dadurch, dass die Stromversorgungsanschlüsse innerhalb eines jeden Stromanschluss-Feldes sowie die Kontaktstifte des zugehörigen Anschlussstücks miteinander korrespondierend in Form eines U angeordnet sind, wobei der U-Rücken zu dem benachbarten Signalanschluss-Feld weist. Die U-förmige Anordnung der Stromversorgungsanschlüsse und Kontaktstifte erlaubt eine Verlagerung der Anschlüsse bzw. Kontaktstifte weg vom Randbereich der Rückverdrahtungsplatine hin zu dem angrenzenden Signalanschluss-Feld. Dabei kann die Zahl der Stromversorgungsanschlüsse eines Stromanschluss-Feldes beibehalten oder sogar noch erhöht werden. Aufgrund des größeren Abstands zum Randbereich der Rückverdrahtungsplatine besteht keine Gefahr eines unerwünschten elektrischen Kontakts mit der Modulschiene. Der zur Stromeinspeisung zur Verfügung stehende Gesamtquerschnitt eines Stromanschluss-Feldes von Stromversorgungsanschlüssen bleibt dabei erhalten oder lässt sich, je nach Anzahl der Stromversorgungsanschlüsse, sogar vergrößern.

Bevorzugt sind bei der U-förmigen Anordnung auf jedem U-Schenkel zwei Stromversorgungsanschlüsse bzw. Kontaktstifte angeordnet. Um dennoch mindestens sechs Anschlusspunkte zu haben, können dann zwei oder drei weitere Anschlüsse auf dem U-Rücken angeordnet sein. Sind mehr als zwei Stromversorgungsanschlüsse bzw. Kontaktstifte auf dem U-Rücken angeordnet, so ergibt sich gegenüber der herkömmlichen Anordnung in zwei parallelen Dreierreihen sogar eine Erhöhung der Anzahl von Anschlüssen um mindestens eins und damit ein entsprechend größerer wirksamer Gesamtquerschnitt für die Einspeisung des Versorgungsstroms.

Bevorzugt wird eine Ausführung, bei der das Anschlussstück einstückig aus gebogenem Blech hergestellt ist, an seiner ebenen Oberseite eine Gewindebohrung zum Anschluss eines Stromkabels aufweist und an seiner Unterseite mindestens sechs Kontaktstifte trägt, die in Form eines U angeordnet sind. Die U-förmige Anordnung der Kontaktstifte erlaubt sogar das Vorsehen von sieben Kontaktstiften, von denen drei auf dem U-Rücken und je zwei auf den U-Schenkeln angeordnet sind. Ein solches Anschlussstück hat einen insgesamt größeren wirksamen Querschnitt für den Stromfluss als ein herkömmliches Anschlussstück mit nur sechs Kontaktstiften. Aufgrund der U-förmigen Anordnung sind die Stromversorgungsanschlüsse und die Kontaktstifte, welche die Rückverdrahtungsplatine durchsetzen und auf deren Rückseite ein Stück herausragen, ausreichend weit vom Randbereich und der dort aufliegenden Modulschiene entfernt.

Als besonders vorteilhaft hat sich eine Ausführungsform herausgestellt, bei der die Kontaktstifte des Anschlussstücks und damit korrespondierend auch die Stromversorgungsanschlüsse derart in U-Form angeordnet sind, dass die beiden am Ende der U-Schenkel angeordneten Kontaktstifte mit dem Mittelpunkt der Gewindebohrung des Anschlussstücks fluchten. Diese Konfiguration führt dazu, dass die Kontaktstifte bzw. Stromversorgungsanschlüsse nicht, wie sonst üblich, symmetrisch, sondern in Richtung des angrenzenden Signalanschluss-Feldes versetzt angeordnet sind. Hierdurch ist es möglich, auch sehr hohe Versorgungsströme in die Rückverdrahtungsplatine einzuspeisen, ohne dass die Gefahr eines Kurzschlusses mit der in der Nähe befindlichen Modulschiene besteht.

Ausführungsbeispiele der Erfindung werden nachstehend anhand der beigefügten Zeichnungen näher erläutert. Es zeigen:
- Fig. 1: einen Baugruppenträger mit einer Rückverdrahtungsplatine, in vereinfachter perspektivischer Ansicht von hinten;
- Fig.2: die Rückverdrahtungsplatine des Baugruppenträgers von Fig. 1, in vergrößerter perspektivischer Ansicht;
- Fig. 3: einen Teil der Rückverdrahtungsplatine von Fig. 2 in einer Draufsicht;
- Fig. 4: einen Querschnitt durch die Modulschiene des Baugruppenträgers von Fig. 1 mit anmontierter Rückverdrahtungsplatine;
- Fig. 5a: das Anschlussstück der Rückverdrahtungsplatine von Fig. 4, in einer Ansicht von vorne;
- Fig. 5b: das Anschlussstück gemäß Fig. 5a, in einer Ansicht von der Seite;
- Fig. 5c: das Anschlussstück gemäß Fig. 5a und Fig. 5b, in einer teilweise geschnittenen Ansicht von unten;
- Fig. 6a: eine alternative Ausführung des Anschlussstücks, in einer Ansicht von vorne;
- Fig. 6b: das Anschlussstück gemäß Fig. 6a, in einer Ansicht von der Seite;
- Fig. 6c: das Anschlussstück gemäß Fig. 6a und Fig. 6b, in einer teilweise geschnittenen Ansicht von unten.

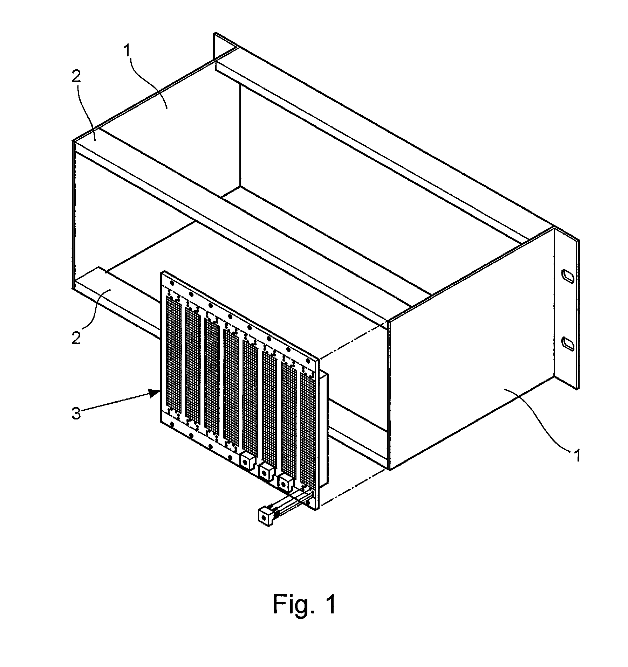

Der in Figur 1 stark vereinfacht dargestellte Baugruppenträger umfasst zwei Seitenwände 1 sowie vier parallele Modulschienen 2, welche die Seitenwände 1 miteinander verbinden. Die Modulschienen 2 sind an ihren Enden mit den Ecken der Seitenwände 1 verschraubt. Die Seitenwände 1 sind im Querschnitt L-förmig ausgebildet, wodurch die typischen Befestigungsflansche für den Einbau des Baugruppenträgers in ein Gestell oder einen Elektronikschrank entstehen. Eine Rückverdrahtungsplatine 3 ist an den hinteren Modulschienen 2 befestigt.

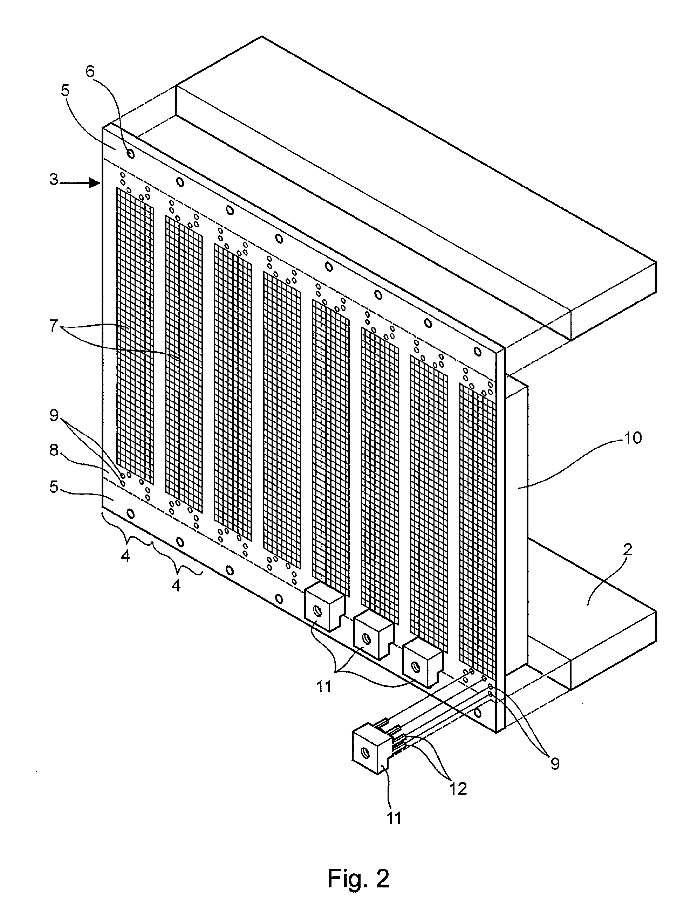

Die in Figur 2 vergrößert dargestellte Rückwandplatine 3 ist als Mehrlagen-Leiterplatte ausgebildet und in mehrere gleichartige, nebeneinander angeordnete Abschnitte 4 unterteilt. Diese Abschnitte 4 weisen eine Breite von ungefähr 20 Millimetern auf. Jeder Abschnitt 4 umfasst einen Randbereich 5 nahe der oberen bzw. unteren Längskante der Rückverdrahtungsplatine 3. In der Mitte eines jeden Randbereichs 5 ist ein Befestigungsloch 6 eingebracht. Jeder Abschnitt 4 umfasst ferner ein Signalanschluss-Feld 7 mit einer Vielzahl von in Spalten und Reihen angeordneten Anschlusspunkten für die (nicht dargestellten) elektronischen Steckbaugruppen. Zwischen dem Signalanschluss-Feld 7 und dem oberen bzw. unteren Randbereich 5 eines jeden Abschnitts 4 befindet sich ein Stromanschluss-Feld 8 von Stromversorgungsanschlüssen 9. Die Anschlusspunkte der Signalanschluss-Felder 7 und die Stromversorgungsanschlüsse 9 sind als durchkontaktierte Löcher ausgebildet. Auf der Innenseite der Rückverdrahtungsplatine 3 sind vielpolige Steckerleisten 10 aufgebracht und mit den Anschlusspunkten des zugehörigen Signalanschluss-Feldes 7 kontaktiert. Die Steckerleisten 10 dienen zur Aufnahme von (nicht dargestellten ) Steckverbindern, die Bestandteil der (nicht dargestellten) elektronischen Steckbaugruppen sind.

Auf der Außenseite der Rückverdrahtungsplatine 3 sind annähernd quaderförmig ausgebildete Anschlussstücke 11 aus gut leitfähigem Metall angeordnet. Eines der Anschlussstücke 11 ist explosionsartig von der Rückverdrahtungsplatine 3 entfernt dargestellt, so dass das zugehörige Stromanschluss-Feld 8 von Stromversorgungsanschlüssen 9 sowie die Kontaktstifte 12 des Anschlussstücks 11 sichtbar sind. Die Stromversorgungsanschlüsse 9 dieses Stromanschluss-Feldes 8 sowie die Kontaktstifte 12 des zugehörigen Anschlussstücks 11 sind miteinander korrespondierend in Form eines U angeordnet.

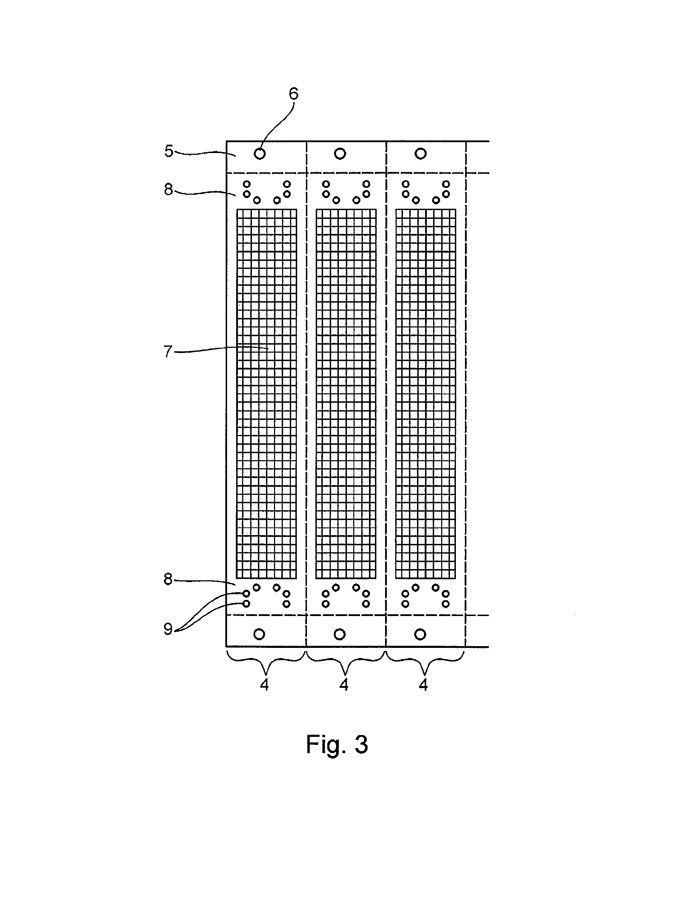

Wie am besten aus der Draufsicht in Figur 3 ersichtlich, gehören zu jedem Stromanschluss-Feld 8 sechs Stromversorgungsanschlüsse 9, die so U-förmig angeordnet sind, dass je zwei Anschlusspunkte 9 auf den beiden U-Schenkeln und zwei weitere Anschlusspunkte 9 auf dem U-Rücken angeordnet sind, wobei der U-Rücken zu dem benachbarten Signalanschluss-Feld 7 weist.

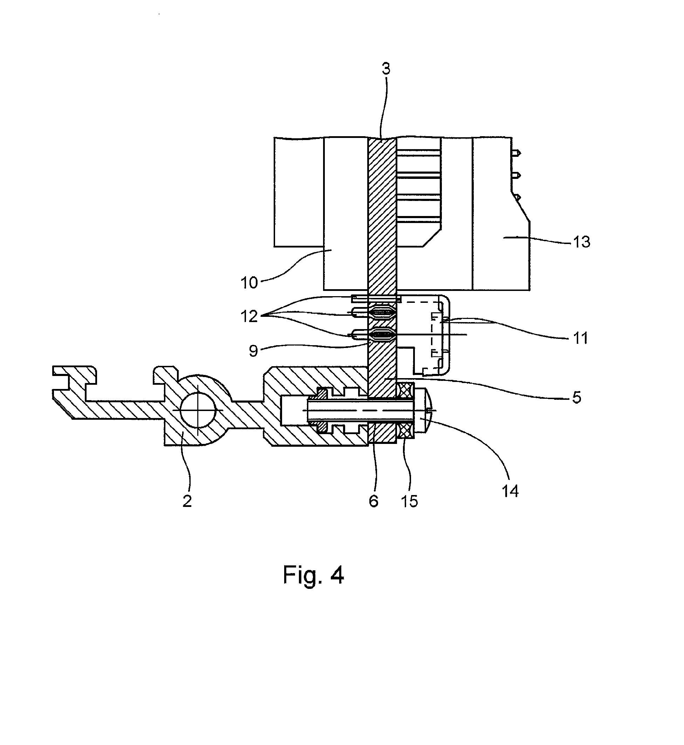

Gemäß Figur 4 liegt die Modulschiene 2 mit ihrer Stirnseite an der Außenseite der Rückverdrahtungsplatine 3 an. Der Randbereich 5 wird von der Modulschiene 2 nahezu vollständig abgedeckt. Durch das Befestigungsloch 6 greift eine Befestigungsschraube 14, mit der die Rückverdrahtungsplatine 3 an der Modulschiene 2 befestigt ist. Zwecks Isolierung der Befestigungsschraube 14 gegenüber der Rückverdrahtungsplatine 3 ist der Kopf der Befestigungsschraube 14 mit einer Isolierscheibe 15 unterlegt. In dem Schnittbild von Figur 4 sind zwei Stromversorgungsanschlüsse 9 zu erkennen, die als Durchkontaktierungen in der Rückverdrahtungsplatine 3 ausgebildet sind. Drei der Kontaktstifte 12 des Anschlussstücks 11 sind erkennbar. Die Kontaktstifte 12 durchsetzen die Stromversorgungsanschlüsse 9 und ragen an der Außenseite der Rückverdrahtungsplatine 3 ca. 2 Millimeter hervor. Aufgrund der U-förmigen Anordnung der Stromversorgungsanschlüsse 9 und der Kontaktstifte 12 ergibt sich ein ausreichender Abstand zu der Modulschiene 2.

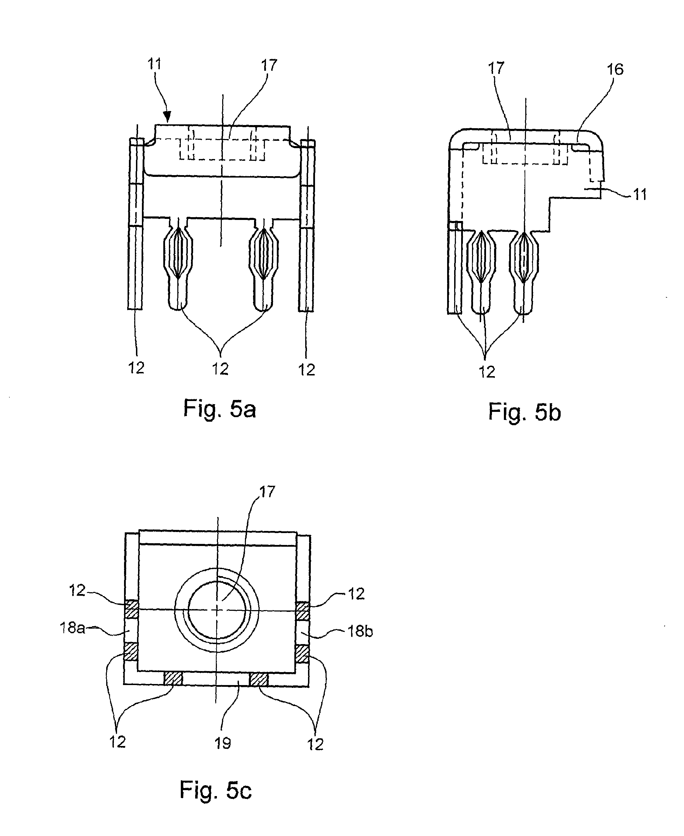

Die Figuren 5a, 5b und 5c zeigen ein Anschlussstück 11 im Detail. Insgesamt sechs Kontaktstifte 12 sind an der Unterseite des Anschlussstücks 11 angeordnet. An seiner Oberseite 16 weist das Anschlussstück 11 eine mittig angeordnete Gewindebohrung 17 der Größe M4 auf. In diese Gewindebohrung 17 kann eine (nicht dargestellte) Klemmschraube zur Befestigung eines Stromkabels eingeschraubt werden. Wie insbesondere aus der Unteransicht in Fig. 5c ersichtlich, sind die Kontaktstifte 12 U-förmig angeordnet, wobei auf dem linken U-Schenkel 18a, dem rechtem U-Schenkel 18b und dem U-Rücken 19 je zwei Kontaktstifte 12 angeordnet sind.

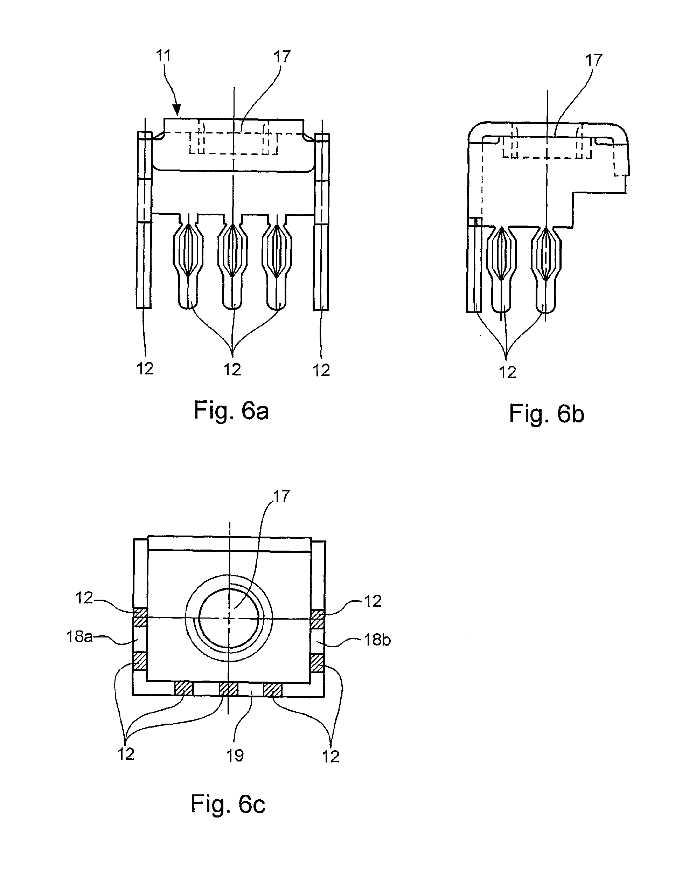

Das in den Figuren 6a, 6b und 6c dargestellte Anschlussstück 11 hat insgesamt sieben Kontaktstifte 12, von denen je zwei auf dem linken U-Schenkel 18a und dem rechten U-Schenkel 18b und drei weitere Kontaktstifte 12 auf dem U-Rücken 19 angeordnet sind. Die jeweils am Ende der beiden U-Schenkel 18a, 18b angeordneten Kontaktstifte 12 liegen mit dem Mittelpunkt der Gewindebohrung 17 auf einer Linie.

### Zusammenstellung der Bezugszeichen

- 1: Seitenwand
- 2: Modulschiene
- 3: Rückverdrahtungsplatine
- 4: Abschnitt (von 3)
- 5: Randbereich
- 6: Befestigungsloch (in 5)
- 7: Signalanschluss-Feld
- 8: Stromanschluss-Feld
- 9: Stromversorgungsanschluss
- 10: Steckerleiste
- 11: Anschlussstück
- 12: Kontaktstift (von 11)
- 13: Steckverbinder
- 14: Befestigungsschraube
- 15: Isolierscheibe
- 16: Oberseite (von 11)
- 17: Gewindebohrung (in 11)
- 18a,18b: U-Schenkel
- 19: U-Rücken

## Patentansprüche

1. Rückverdrahtungsplatine für elektronische Steckbaugruppen, welche an mindestens einer Modulschiene eines Baugruppenträgers befestigbar ist, mit
- wenigstens einem Randbereich (5) mit einem Befestigungsloch (6);
- mindestens einem Signalanschluss-Feld (7);
- wenigstens einem Stromanschluss-Feld (8) von Stromversorgungsanschlüssen (9) zwischen dem Signalanschluss-Feld (7) und dem Randbereich (5);
- mindestens einem Anschlussstück (11) mit Kontaktstiften (12), die mit den Stromversorgungsanschlüssen (9) des zugehörigen Stromanschluss-Feldes (8) kontaktiert sind;
**dadurch gekennzeichnet,dass** die Stromversorgungsanschlüsse (9) eines Stromanschluss-Feldes (8) sowie die Kontaktstifte (12) des zugehörigen Anschlussstücks (11) miteinander korrespondierend in Form eines U angeordnet sind, wobei der U-Rücken (19) zu dem benachbarten Signalanschluss-Feld (7) weist.

2. Rückverdrahtungsplatine nach Anspruch 1, **dadurch gekennzeichnet, dass** auf jedem U-Schenkel (18a, 18b) zwei Stromversorgungsanschlüsse (9) bzw. Kontaktstifte (12) angeordnet sind.

3. Rückverdrahtungsplatine nach Anspruch 1 oder 2, **dadurch gekennzeichnet,dass** auf dem U-Rücken (19) mindestens zwei Stromversorgungsanschlüsse (9) bzw. Kontaktstifte (12) angeordnet sind.

4. Rückverdrahtungsplatine nach einem der Ansprüche 1 bis 3, **dadurch gekennzeichnet, dass** dass Anschlussstück (11) einstückig aus gebogenem Blech hergestellt ist, an seiner ebenen Oberseite (16) eine Gewindebohrung (17) zum Anschluss eines Stromkabels aufweist und an seiner Unterseite mindestens sechs Kontaktstifte (12) trägt, die in Form eines U angeordnet sind.

5. Rückverdrahtungsplatine nach Anspruch 4, **dadurch gekennzeichnet, dass** das Anschlussstück (11) sieben Kontaktstifte hat, von denen drei auf dem U-Rücken (19) und je zwei auf den U-Schenkeln (18a, 18b) angeordnet sind.

6. Rückverdrahtungsplatine nach Anspruch 5, **dadurch gekennzeichnet, dass** die beiden am Ende der U-Schenkel (18a, 18b) angeordneten Kontaktstifte (12) mit dem Mittelpunkt der Gewindebohrung (17) fluchten.
